(19) Europäisches Patentamt / European Patent Office / Office européen des brevets

(11) **EP 4 105 671 A1**

(12) **EUROPÄISCHE PATENTANMELDUNG**

(43) Veröffentlichungstag:
**21.12.2022  Patentblatt 2022/51**

(21) Anmeldenummer: **21179707.1**

(22) Anmeldetag: **16.06.2021**

(51) Internationale Patentklassifikation (IPC):
**G01R 33/24** *(2006.01)*       **G01R 33/565** *(2006.01)*

(52) Gemeinsame Patentklassifikation (CPC):
**G01R 33/243; G01R 33/56518; G01R 33/56563; G01R 33/56572;** G01R 33/3802; G01R 33/387

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH
91052 Erlangen (DE)**

(72) Erfinder: **Popescu, Stefan
91056 Erlangen (DE)**

(54) **VERFAHREN ZUR ERMITTLUNG EINES MAGNETFELDES ZUMINDEST EINER MAGNETSPULENEINHEIT EINER MAGNETRESONANZVORRICHTUNG, MAGNETRESONANZVORRICHTUNG UND COMPUTERPROGRAMMPRODUKT**

(57)    Die Erfindung betrifft ein Verfahren zur Ermittlung eines Magnetfeldes zumindest einer Magnetspuleneinheit einer Magnetresonanzvorrichtung, eine Magnetresonanzvorrichtung und ein Computerprogrammprodukt. Gemäß dem Verfahren wird durch die zumindest eine Magnetspuleneinheit das Magnetfeld erzeugt. An verschiedenen Stellen des Magnetfeldes werden mittels einer Magnetfeldsensoreinheit mehrere Magnetfeldvektoren erfasst, wobei jeder der mehreren Magnetfeldvektoren eine Stärke, insbesondere einen Betrag, und eine Richtung des Magnetfeldes an der jeweiligen Stelle beschreibt. Das Magnetfelde wird ermittelt, wobei zur Ermittlung des Magnetfeldes anhand der mehreren Magnetfeldvektoren ein Modell eines Vektorfeldes ermittelt wird.

FIG 6

**Beschreibung**

Die Erfindung betrifft ein Verfahren zur Ermittlung eines Magnetfeldes zumindest einer Magnetspuleneinheit einer Magnetresonanzvorrichtung, eine Magnetresonanzvorrichtung und ein Computerprogrammprodukt.

In der Medizintechnik zeichnet sich die Bildgebung mittels Magnetresonanz (MR), auch Magnetresonanztomographie (MRT, engl. Magnetic Resonance Imaging, MRI) genannt, durch hohe Weichteilkontraste aus. Hierbei wird typischerweise ein menschlicher oder tierischer Patient in einem Bildgebungsvolumen einer Magnetresonanzvorrichtung positioniert. Während einer Magnetresonanzmessung werden üblicherweise mit Hilfe einer Hochfrequenzantenneneinheit einer Magnetresonanzvorrichtung hochfrequente Anregungspulse in den Patienten eingestrahlt. Davon zu unterscheiden ist ein durch eine Magnetspuleneinheit der Magnetresonanzvorrichtung erzeugtes Magnetfeld, das üblicherweise ein statisches Hauptmagnetfeld und/oder ein Gradientenmagnetfeld umfasst. Das Hauptmagnetfeld, auch $B_0$-Feld genannt, wird von einem, beispielsweise supraleitenden, Hauptmagneten erzeugt. Ferner werden mit Hilfe einer Gradientenspuleneinheit der Magnetresonanzvorrichtung Gradientenmagnetfelder, insbesondere Gradientenpulse, erzeugt, die üblicherweise zur Ortskodierung dienen. Die Gradientenspuleneinheit kann mehrere Gradientenspulen umfassen, wobei jede der mehreren Gradientenspulen zur Erzeugung eines (Teil-)Gradientenmagnetfeldes in eine bestimmte Raumrichtung, z.B. X, Y und Z, ausgelegt ist. Durch die erzeugten Sendepulse werden im Patienten Kernspins angeregt, wodurch ortskodierte Magnetresonanzsignale ausgelöst werden. Die Magnetresonanzsignale werden von der Magnetresonanzvorrichtung empfangen und zur Rekonstruktion von Magnetresonanzabbildungen verwendet.

Im gesamten folgenden Verlauf der Offenbarung werden fettgedruckte Symbole zur Bezeichnung von Vektorgrößen verwendet (beispielsweise ist $B$ der Vektorwert des Magnetfelds) und normale Symbole zur Bezeichnung des Betrags dieser Vektoren, d.h. $B=|B|$.

Idealisierend werden in der Regel für das Magnetfeld, das zur Erzeugung und Ortskodierung der Magnetresonanzsignale verwendet wird, bestimmte Randbedingungen angenommen.

Insbesondere wird angenommen, dass die Stärke des statischen Hauptmagnetfelds $B_0$ in einem Bildgebungsvolumen, insbesondere in einem Sichtbereich (engl. field of view, FOV), homogen ist oder eine gleichförmige Verteilung mit einer Präzision von weniger als ein paar Millionstel (engl. parts per million, ppm) aufweist. Ferner wird insbesondere angenommen, dass die Feldlinien des Magnetfelds perfekt gerade und/oder parallel zueinander verlaufen, indem beispielsweise das statische Magnetfeld $B_0$ entlang einer, insbesondere axialen, Z-Richtung orientiert, d.h. $B_0=BZ_0$, und keine transversalen Komponenten in zur Z-Richtung orthogonalen Richtungen X und Y vorhanden sind, d.h. $BX_0=BY_0=0$. Ferner wird angenommen, dass ein Gradientenmagnetfeld, das von einer eine Gradientenspule zur Erzeugung eines Gradientenmagnetfelds in einer bestimmten Richtung erzeugt wird, auch ausschließlich entlang dieser Richtung orientiert ist und sich die Stärke des Magnetfelds linear proportional verändert. Beispielsweise wird für eine Gradientenspule zur Erzeugung eines Gradientenmagnetfelds in Z-Richtung angenommen, dass sie ein Gradientenmagnetfeld erzeugt, das ausschließlich entlang der, insbesondere axialen, Z-Richtung orientiert ist und sich die Stärke des Magnetfelds BZ0 linear proportional zur Ortskoordinate (x,y,z) verändert: $BZ(x,y,z) = BZ_0+GX\cdot x+GY\cdot y+GZ\cdot z$ mit $BX(x,y,z) = BY(x,y,z) =0$

Leider weichen die realen Verhältnisse beim Durchführen einer Magnetresonanzmessung aufgrund verschiedener Fehlerquellen mitunter stark von den oben beschriebenen idealisierten Annahmen ab. So ist beispielsweise seit langem bekannt, dass die Gradientenspulen kein ideales magnetisches Ortskodierungsfeld erzeugen. So sind die Magnetfeldgradient nicht perfekt linear, was geometrische Verzerrungen in den Magnetresonanzabbildungen hervorruft. Zudem weisen tatsächliche von Gradientenspulen erzeugte Magnetfelder auch Komponenten auf, die nicht parallel, sondern orthogonal zur gewünschten Richtung sind. Solche orthogonalen Komponenten werden auch als sogenannte "concomitant" Terme oder Maxwell-Terme bezeichnet, z.B. in M.A. Bernstein et al., Concomitant gradient terms in phase contrast MR: Analysis and correction, Magnetic Resonance in Medicine, 39, 2, (300-308), (2021). Diese Terme sind eine unvermeidbare Konsequenz der physikalischen Naturgesetze (beschrieben durch die Maxwell-Gleichungen), welche erforderlich machen, dass innerhalb des Bildgebungsvolumen das magnetische Vektorfeld eine verschwindende Divergenz, d.h. Divergenz ist gleich null, und eine vernachlässigbare Rotation aufweisen müssen.

Ein weiteres Problem ist mit den Wirbelströmen verbunden, die die Gradientenspuleneinheit in elektrisch leitfähige Teile der Magnetresonanzvorrichtung induziert, beispielsweise das Gehäuse eines supraleitenden Magneten und/oder in die Kryoabschirmungen. Diese Wirbelströme erzeugen wiederum zusätzliche und stark nichtlineare orthogonale Magnetfelder, die das ursprüngliche Gradientenfeld überlagern, so dass sie zusätzliche Kodierungsfehler in den Magnetresonanzsignalen verursachen.

Alle diese Fehlerquellen können Artefakte in den rekonstruierten Magnetresonanzabbildungen erzeugen. Zu deren Reduzierung wurden bereits in der Vergangenheit Versuche unternommen. Ein Ansatz stellt die Verwendung einer kommerziell erhältlichen sogenannten dynamischen Feldkamera (engl. dynamic field camera, DFC) dar. Diese Kamera umfasst eine Vielzahl an aktiven Magnetfeldsonden, um die Stärke des Magnetfelds an bestimmten Stellen einer Oberfläche einer Kugel, die ein Bildgebungsvolumen einschließt, zu messen. Auch in den Druckschriften US5055791A und US20150338475A1 werden Verfahren zur Bestimmung eines Magnetfelds beschrieben.

Die Aufgabe der vorliegenden Erfindung kann darin gesehen werden, ein verbessertes Verfahren zur Bestimmung eines Magnetfeldes einer Magnetresonanzvorrichtung anzugeben. Insbesondere besteht das Bedürfnis das Magnetfeld noch präziser als bisher zu bestimmen.

Die Aufgabe wird durch die Merkmale der unabhängigen Ansprüche gelöst. Vorteilhafte Ausgestaltungen sind in den abhängigen Ansprüchen beschrieben.

Demnach wird ein Verfahren zur Ermittlung eines Magnetfeldes zumindest einer Magnetspuleneinheit einer Magnetresonanzvorrichtung, insbesondere eines Hauptmagneten zum Erzeugen eines Hauptmagnetfeldes und/oder eine Gradientenspuleneinheit zum Erzeugen eines Gradientenmagnetfeldes. Dabei wird durch die zumindest eine Magnetspuleneinheit das Magnetfeld erzeugt. An verschiedenen Stellen des Magnetfeldes werden mittels einer Magnetfeldsensoreinheit mehrere Magnetfeldvektoren erfasst, wobei jeder der mehreren Magnetfeldvektoren eine Stärke, insbesondere einen Betrag, und eine Richtung des Magnetfeldes an der jeweiligen Stelle beschreibt. Eine Stelle kann insbesondere eine Position und/oder ein Punkt im Raum sein. Ferner wird das Magnetfeld ermittelt, wobei zur Ermittlung des Magnetfeldes anhand der mehreren Magnetfeldvektoren ein Modell eines Vektorfeldes ermittelt wird. Insbesondere kann das ermittelte Magnetfeld als Modell des Vektorfeldes beschrieben werden.

Vorteilhafterweise kann anhand des ermittelten Magnetfeldes das Magnetfeld korrigiert werden und/oder bei einer Rekonstruktion von Magnetresonanzsignalen berücksichtigt werden. Eine Korrektur des Magnetfeldes kann insbesondere mit Hilfe einer Anpassung eines Stromflusses durch die Gradientenspuleneinheit und/oder durch dezidierte Shim-Spulen erfolgen.

Eine Ausführungsform des Verfahrens sieht vor, dass die verschiedenen Stellen, an denen die mehreren Magnetfeldvektoren erfasst werden, auf einer Fläche liegen, die ein Volumen des zu ermittelnden Magnetfeldes, insbesondere eines Bildgebungsvolumen einer Magnetresonanzmessung, einschließt.

Eine weitere Ausführungsform des Verfahrens sieht vor, dass wobei die Fläche eine sphärische Fläche, insbesondere eine Kugeloberfläche, ist.

Vorzugsweise erfolgt die Erfassung der Magnetfeldvektoren mit Hilfe einer statischen oder dynamischen Feldkamera.

Vorzugsweise umfasst die Magnetfeldsensoreinheit zumindest einen Magnetfeldsensor, der zum Erfassen der mehreren Magnetfeldvektoren nacheinander an zumindest einem Teil der mehreren Stellen, insbesondere mittels eines Roboters, positioniert wird.

Vorzugsweise umfasst die Magnetfeldsensoreinheit mehrere Magnetfeldsensoren, die zum Erfassen der mehreren Magnetfeldvektoren gleichzeitig an zumindest einem Teil der mehreren Stellen positioniert sind.

Eine weitere Ausführungsform des Verfahrens sieht vor, dass anhand des ermittelten Magnetfeldes eine Qualitätskontrolle des Hauptmagneten und/oder der Gradientenspuleneinheit während der Herstellung der Magnetresonanzvorrichtung durchgeführt wird.

Eine weitere Ausführungsform des Verfahrens sieht vor, dass zur Ermittlung des Magnetfeldes das Modell des Vektorfeldes in separate, insbesondere orthogonale, Teilmodelle zerlegt wird.

Eine weitere Ausführungsform des Verfahrens sieht vor, dass die Ermittlung des Modells des Vektorfeldes eine Entwicklung des Vektorfeldes nach, insbesondere skalaren und reellwertigen, Kugelflächen-Basisfunktionen umfasst.

Vorzugsweise sieht das Vektormodell vor, das Magnetfeld anhand von drei, insbesondere orthogonalen, skalaren Komponenten zu beschreiben, wobei zur Ermittlung des Magnetfeldes auf jede der drei Komponenten ein voneinander unabhängiges Teilvektormodell angewendet wird.

Vorzugsweise werden die drei separaten Teilvektormodelle zu einem gesamten Vektormodell kombiniert.

Eine weitere Ausführungsform des Verfahrens sieht vor, dass zur Ermittlung des Magnetfeldes das Vektormodell an die erfassten mehreren Magnetfeldvektoren gefittet wird.

Vorzugsweise umfasst das Fitten des Vektormodells an die erfassten mehreren Magnetfeldvektoren eine Ermittlung von den Kugelflächen-Basisfunktionen zugeordneten Koeffizienten.

Vorzugsweise wird zur Ermittlung der den Kugelflächen-Basisfunktionen zugeordneten Koeffizienten ein, insbesondere lineares, Gleichungssystem gelöst.

Eine weitere Ausführungsform des Verfahrens sieht vor, dass die Ermittlung des Magnetfeldes eine Ermittlung eines dynamischen Modells eines Vektorfeldes umfasst.

Vorzugsweise wird anhand des dynamischen Modells des Vektorfeldes eine Vektor-Gradientenimpulsantwortfunktion kalibriert.

Vorzugsweise wird ein dynamisches Verhalten des Magnetfeldes durch Erzeugen zumindest eines Gradientenmagnetfeldes bestimmt.

Insbesondere können anhand des dynamischen Verhaltens des Magnetfeldes dynamische, insbesondere durch Wirbelströme verursachte, Abweichungen des Magnetfeldes kalibriert werden.

Eine weitere Ausführungsform des Verfahrens sieht vor, dass zur Ermittlung des Magnetfeldes mehrere Teilbeiträge des Magnetfeldes vektoriell kombiniert, insbesondere addiert, werden.

Eine weitere Ausführungsform des Verfahrens sieht vor, dass an zumindest einer der verschiedenen Stellen ein erster Ort einer Erfassung einer ersten Komponente des an dieser Stelle erfassten Magnetfeldvektors einen Versatz zu einem zweiten Ort einer zweiten Komponente des an dieser Stelle erfassten Magnetfeldvektors aufweist, wobei der Versatz bei der Ermittlung des Magnetfeldes berücksichtigt wird.

Ferner wird eine Vorrichtung zur Ermittlung eines Magnetfeldes einer zumindest einer Magnetspuleneinheit vorgeschlagen. Die Vorrichtung umfasst eine Magnetspuleneinheit zum Erzeugen des Magnetfelds, eine Magnetfeldsensoreinheit zum Erfassen mehrerer Magnetfeldvektoren an verschiedenen Stellen des Magnetfeldes und eine Auswerteeinheit zur Ermittlung des Magnetfeldes.

Die Vorteile der Vorrichtung zur Ermittlung eines Magnetfeldes zumindest einer Magnetspuleneinheit entsprechen im Wesentlichen den Vorteilen des erfindungsgemäßen Verfahrens zur Ermittlung eines Magnetfeldes zumindest einer Magnetspuleneinheit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Ferner wird ein Computerprogrammprodukt vorgeschlagen, das ein Programm umfasst und direkt in einen Speicher einer programmierbaren Auswerteeinheit, insbesondere einer Magnetresonanzvorrichtung, ladbar ist und Programmmittel, z.B. Bibliotheken und Hilfsfunktionen, aufweist, um ein Magnetfeld anhand erfasster Magnetfeldvektoren zu ermitteln, wenn das Computerprogrammprodukt in der Auswerteeinheit ausgeführt wird. Das Computerprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Auswerteeinheit zu laden ist. Durch das Computerprogrammprodukt kann das erfindungsgemäße Verfahren schnell, identisch wiederholbar und robust ausgeführt werden. Das Computerprogrammprodukt ist so konfiguriert, dass es mittels der Auswerteeinheit die erfindungsgemäßen Verfahrensschritte ausführen kann. Die Auswerteeinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer lokalen Auswerteeinheit geladen werden kann, der beispielsweise mit der Magnetresonanzvorrichtung direkt verbunden oder als Teil der Magnetresonanzvorrichtung ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Auswerteeinheit ein erfindungsgemäßes Verfahren durchführen. Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Auswerteeinheit gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:

Fig. 1 eine Magnetresonanzvorrichtung mit einer Magnetfeldsensoreinheit,

Fig. 2 ein möglicher Ablauf eines Verfahrens zur Ermittlung eines Magnetfeldes zumindest einer Magnetspuleneinheit einer Magnetresonanzvorrichtung,

Fig. 3 eine durch eine planare Gradientenspule erzeugte Magnefeldverteilung,

Fig. 4 eine Tabelle beschreibend skalare und vektorielle Kugelflächenfunktionen bis zur dritten Ordnung,

Fig. 5 ein eine Kugelfläche beschreibendes Abtastmuster mit 480 Abtaststellen,

Fig. 6 eine Darstellung erfasster Magnetfeldvektoren,

Fig. 7 ein Magnetometer mit zwei unabhängigen Teilsensoren.

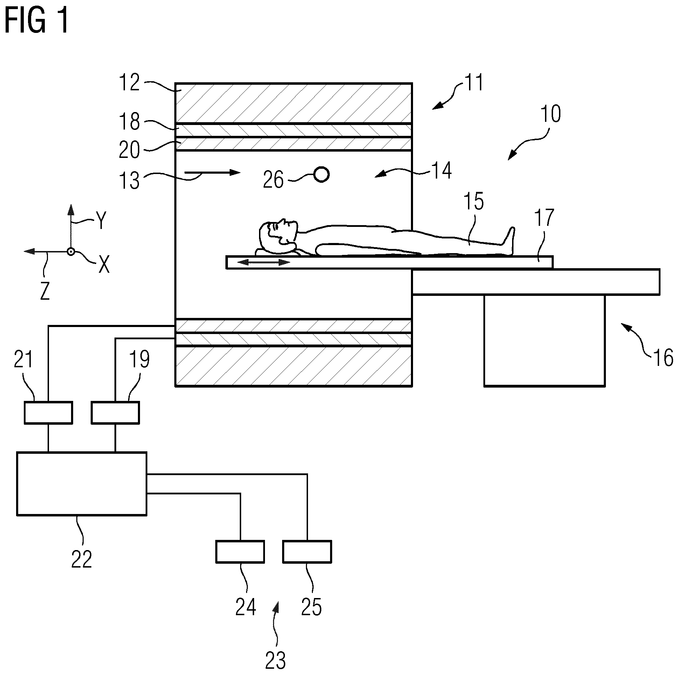

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und umfasst ein Bildgebungsvolumen, in dem bildgebende Magnetresonanzsignale erzeugt werden. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 umfasst weiterhin eine Gradientenspuleneinheit 18 zu einer Erzeugung eines für eine Ortskodierung während einer Bildgebung verwendeten Gradientenmagnetfeldes, das dem Hauptmagnetfeld überlagert wird. Die Gradientenspuleneinheit 18 umfasst insbesondere drei hier nicht im Detail dargestellte Gradientenspulen, wobei eine erste der drei Gradientenspulen zur Erzeugung eines Magnetfeldgradienten entlang der Achse $X$, eine zweite der drei Gradientenspulen zur Erzeugung eines Magnetfeldgradienten entlang der Achse $Y$ und eine dritte der drei Gradientenspulen zur Erzeugung eines Magnetfeldgradienten entlang der Achse $Z$ vorgesehen sind. Die Gradientenspuleneinheit 18 wird mittels einer Gradientensteuereinheit 19 der Magnetresonanzvorrichtung 10 gesteuert.

Die Magnetresonanzvorrichtung 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Die Hochfrequenzantenneneinheit 20 wird von einer Hochfrequenzantennensteuereinheit 21 der Magnetresonanzvorrichtung 10 gesteuert und strahlt hochfrequente Magnetresonanzsequenzen in das Bildgebungsvolumen ein. Dadurch stellt sich in dem Bildgebungsvolumen eine Anregung von Atomkernen ein. Durch Relaxation der angeregten Atomkerne werden Magnetresonanzsignale erzeugt. Die Hochfrequenzantenneneinheit 20 ist zum Empfang der Magnetresonanzsignale ausgebildet.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten bildgebenden Gradientenechosequenz. Zudem umfasst die Systemsteuereinheit 22 eine nicht näher dargestellte Auswerteeinheit Ermittlung des durch den Hauptmagneten 11 und/oder der Gradientenspuleneinheit 18 erzeugten Magnetfelds.

Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Ferner umfasst die Magnetresonanzvorrichtung 10 eine Magnetfeldsensoreinheit 26 zum Erfassen des Magnetfeldes, insbesondere zum Erfassen zumindest eines Magnetfeldvektors. Die Magnetfeldsensoreinheit 26 kann beispielsweise eine, insbesondere statische oder dynamische, Feldkamera und/oder einen oder mehrere Magnetometer umfassen.

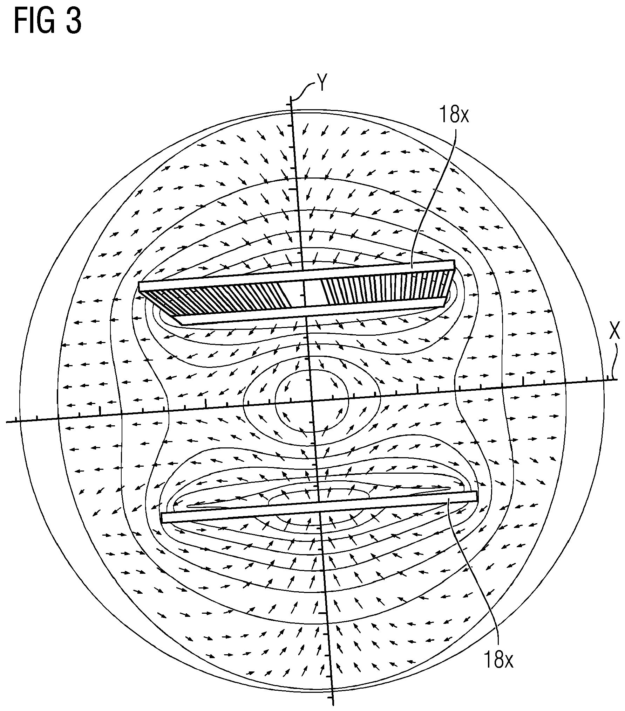

Anhand von Fig. 3 soll beispielhaft gezeigt werden, dass eine Gradientenspule zur Erzeugung eines Magnetfeldgradienten entlang der bestimmten Achse, hier der $X$-Achse, tatsächlich auch Magnetfeldkomponenten erzeugt, die nicht in Richtung der bestimmten Achse ausgerichtet sind. Die hier dargestellte Verteilung des Magnetfeldes wird von einer ebenen Gradientenspule 18x erzeugt. Obwohl diese Gradientenspule 18x nur dafür gedacht ist, ein Magnetfeld entlang der $X$-Achse zu erzeugen, weist das Magnetfeld eine quadrupolare Verteilung auf, so dass auch ein "concomitant" Gradiententerm entlang der $Y$-Achse auftritt. Mit Hilfe der hier offenbarten Ansätze können solche und andere Abweichungen bei einer Ermittlung des Magnetfelds besser berücksichtigt werden.

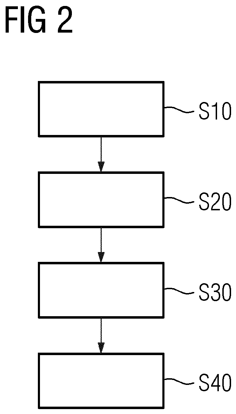

In Fig. 2 soll beispielhaft ein Verfahren zur Ermittlung eines Magnetfeldes zumindest einer Magnetspuleneinheit einer Magnetresonanzvorrichtung illustriert werden. In S10 wird ein Magnetfeld durch zumindest eine Magnetspuleneinheit, insbesondere durch den Hauptmagneten 11 und/oder die Gradientenspuleneinheit 18, erzeugt. In S20 werden mehrere Magnetfeldvektoren an verschiedenen Stellen des Magnetfeldes mittels einer Magnetfeldsensoreinheit erfasst, wobei jeder der mehreren Magnetfeldvektoren eine Stärke, insbesondere einen Betrag, und eine Richtung des Magnetfeldes an der jeweiligen Stelle beschreibt. In S30 wird das Magnetfeld ermittelt, wobei zur Ermittlung des Magnetfeldes anhand der mehreren Magnetfeldvektoren ein Modell eines Vektorfeldes ermittelt wird. In S40 wird das ermittelte Magnetfeld weiterverarbeitet, beispielsweise indem das reale Magnetfeld korrigiert wird und/oder das ermittelte Magnetfeld bei einer Rekonstruktion von durch die Magnetresonanzvorrichtung 10 empfangenen Magnetresonanzsignalen berücksichtigt wird.

Die folgenden Erklärungen dienen als Hintergrund zum besseren Verständnis der Erfindung:
Ein skalares Feld (kurz Skalarfeld) oder ein vektorielles Feld (kurz Vektorfeld), das bei Anwendung des Laplace-Operators (engl. Laplacian) $\Delta$ darauf gleich Null ist, nennt man ein harmonisches Feld (engl. harmonic field). Skalare Kugelflächenfunktionen (engl. spherical harmonic function oder spherical harmonics) $f(r)$ und vektorielle Kugelflächenfunktionen $F(r)$ sind orthogonale Lösungen der Laplace-Gleichung, d.h. $\Delta f(r)=0$ und $\Delta F(r)=0$. Das Vektorfeld lässt sich in kartesische Koordinaten ausdrücken durch $F(x,y,z)=iF_X(x,y,z)+ jF_y(x,y,z)+kF_z(x,y,z)$ bezogen auf den Ortsvektor $r(x,y,z)= ix+jy+kz$.

Jedes harmonische Feld kann zerlegt werden in eine gewichtete Summe von orthogonalen Kugelflächenfunktionen. Ein Modell eines Vektorfeldes lässt sich beschreiben als eine gewichtete Summe von vektoriellen Kugelflächenfunktionen. Ein Modell eines Skalarfeldes lässt sich beschreiben als eine gewichtete Summe von skalaren Kugelflächenfunktionen.

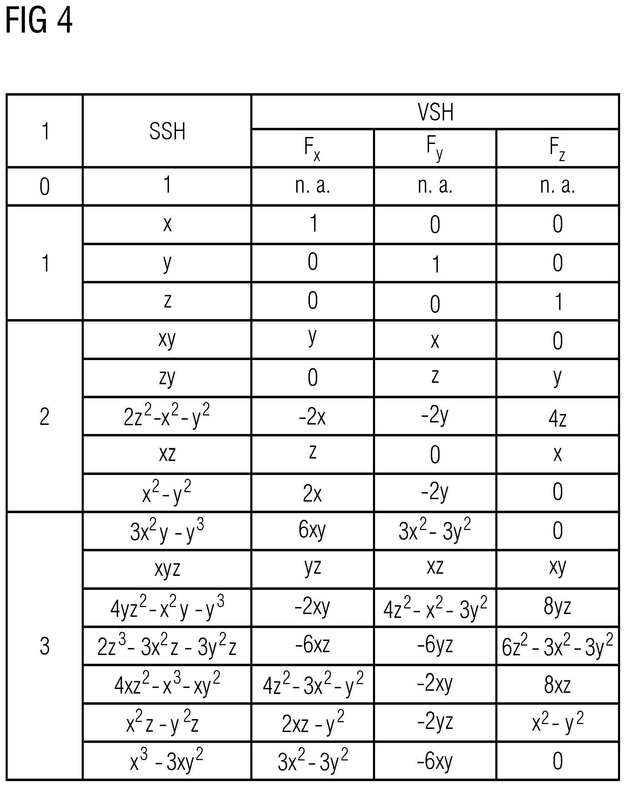

Während die Terme in der in Fig. 4 dargestellten Tabelle für die skalaren Kugelflächenfunktionen SSH in der zweiten Spalte aus dem Stand der Technik bekannt sind, hat der Erfinder die in der dritten, vierten und fünften Spalte dargestellten Terme für die korrespondierenden vektoriellen Kugelflächenfunktionen VSH für die ersten drei Ordnungen *l* analytisch berechnet, indem er den Gradienten-Operator auf die skalaren Kugelflächenfunktionen aus der zweiten Spalte angewendet hat.

Beispielsweise lässt sich die mit der skalaren Kugelflächenfunktion $SSH(r)=2 z^2-x^2-y^2$ korrespondierende vektorielle Kugelflächenfunktion **VSH(r)** ausdrücken mit $VSH(r)=i(-2x)+ j(-2y)+k(4z)$ .

Der Erfinder hat folgende wichtige Erkenntnisse zur verbesserten Ermittlung eines Magnetfeldes einer Magnetresonanzvorrichtung angewendet: Innerhalb der räumlichen Bereiche, in denen kein elektrischer Strom fließt, lässt sich das Magnetfeld in Form eines Vektorfeldes **B** als harmonisches Feld beschreiben. Dagegen verhält sich das Skalarfeld $B=|B|$ nicht notwendigerweise wie ein harmonisches Feld. Dies wird im Folgenden gezeigt:

Gemäß den Maxwell-Gleichungen

$$\begin{cases} \nabla \times \boldsymbol{B} = \mu_0 \boldsymbol{J} + \dfrac{1}{c^2} \dfrac{\partial \boldsymbol{E}}{\partial t} \\ \\ \nabla \cdot \boldsymbol{B} = 0 \end{cases}$$

muss für einen magnetostatischen Zustand innerhalb des ganzen Bildgebungsvolumen das Vektorfeld **B** eine verschwindende Divergenz und eine vernachlässigbare Rotation aufweisen, da der Verschiebungsstrom und der "echte" Strom ignoriert werden können. Da üblicherweise keine Metalle innerhalb des Bildgebungsvolumens vorhanden sind, tritt auch kein elektrischer Strom auf (**J**=0) und dielektrische Effekte können zumindest für statische oder quasi-statische Zustände vernachlässigt werden (**E** ist zeitlich konstant). Verschiebungsströme, die bei einer Magnetresonanzuntersuchung innerhalb des Bildgebungsvolumens auftreten dürfen, sind durch regulatorische Vorgaben ohnehin auf weniger als 100μA beschränkt, um periphere Nerven- und/oder direkte Muskelstimulationen zu vermeiden. Somit können die oben genannten Maxwell-Gleichungen im Falle eines quasi-statischen Zustands vereinfacht werden zu:

$$\begin{cases} \nabla \times \boldsymbol{B} = 0 \\ \\ \nabla \cdot \boldsymbol{B} = 0 \end{cases}$$

Der Laplace-Operator angewendet auf das Vektorfeld **B** lässt sich mathematisch formulieren als $\Delta \boldsymbol{B} = \nabla(\nabla \cdot \boldsymbol{B}) - \nabla \times (\nabla \times \boldsymbol{B})$. Setzt man hier die vereinfachten Maxwell-Gleichungen ein, ergibt sich $\Delta \boldsymbol{B}=0$, d.h. das Vektorfeld **B** ist ein harmonisches Feld. Ausgedrückt in kartesischen Koordinaten erhält man:

$$\Delta \boldsymbol{B} = \frac{\partial^2 \boldsymbol{B}}{\partial x^2} + \frac{\partial^2 \boldsymbol{B}}{\partial y^2} + \frac{\partial^2 \boldsymbol{B}}{\partial z^2} = \boldsymbol{i} \Delta B_x + \boldsymbol{j} \Delta B_y + \boldsymbol{k} \Delta B_z = 0$$

Diese Analyse des Erfinders führt schließlich zu der wichtigen Erkenntnis:

$$\Delta B_x = \Delta B_y = \Delta B_z = 0$$

Das bedeutet, dass nicht nur das Vektorfeld **B** selbst, sondern auch seine drei orthogonalen skalaren Komponenten $B_x$, $B_y$ und $B_z$ jeweils harmonische Felder sind bzw. sich als solche beschreiben lassen. Diese fundamental neue und überraschende Erkenntnis wendet der Erfindung an, um das Magnetfeld auf eine verbesserte Weise zu ermitteln. Insbesondere ermöglicht diese Erkenntnis, dass Modell des Magnetfeldes zu optimieren. Insbesondere kann dadurch das Magnetfeld genauer und/oder schneller ermittelt werden.

So folgt insbesondere daraus, dass es ausreichend ist, Magnetfeldvektoren, also das vektorielle Magnetfeld, an einer gewissen Anzahl von, insbesondere diskrete, örtlichen Stellen zu erfassen, um damit das Magnetfeld, insbesondere eine Verteilung und/oder ein Modell des Magnetfeldes, zu ermitteln. Vorteilhafterweise umfasst das Volumen des dadurch ermittelten Magnetfeldes das gesamte Bildgebungsvolumen, insbesondere das gesamte Volumen, das durch die Stellen, an denen das vektorielle Magnetfeld erfasst wird, eingeschlossen wird.

Konventionell werden hingegen skalare Magnetfeldmodelle angewendet; zwar ist eine harmonische Zerlegung eines skalaren Betrags $B=|\boldsymbol{B}|$ des vektoriellen Magnetfelds $\boldsymbol{B}$ harmonisch, nicht jedoch notwendigerweise das daraus resultierende Feldmodell. Damit ist ein solches Feldmodell nicht genau.

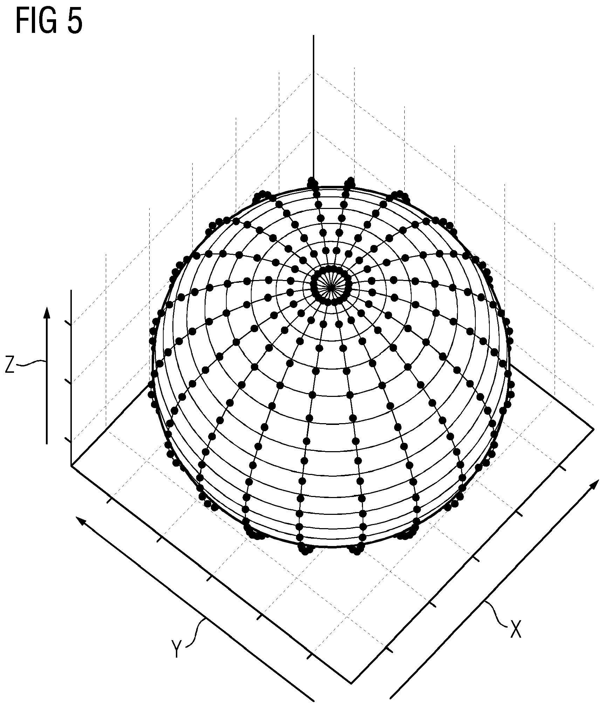

Wie beispielhaft in Fig. 5 dargestellt wird, können insbesondere an N verschiedenen Stellen, die auf einer Fläche verteilt sind, die ein Bildgebungsvolumen der Magnetresonanzvorrichtung einschließt, jeweils ein Magnetfeldvektor erfasst werden. Diese ergeben dann einen Satz an N mehrdimensionalen, insbesondere dreidimensionalen, Abtastpunkten. Die Erfassung der Magnetfeldvektoren kann beispielsweise mit Hilfe einer statischen oder dynamischen Feldkamera erfolgen.

Eine statische Feldkamera eignet sich besonders für die Abtastung einer Feldverteilung, welche sich über den Zeitraum, in welchem die Abtastung der N Messpunkte erfolgt, nicht oder nur wenig ändert. Eine statische Feldkamera kann beispielsweise nur ein (vektorielles) Magnetometer umfassen, das mit Hilfe eines robotischen Armes nacheinander an den N Erfassungsstellen positioniert wird.

Eine dynamische Feldkamera umfasst beispielsweise N (vektorielle) Magnetometer, die auf einer Trägerstruktur angeordnet sind, so dass die die Magnetometer an den N Erfassungsstellen positioniert sind. Mit so einer Kamera kann beispielsweise eine dynamische Entwicklung eines Magnetfeldes erfasst werden, die insbesondere durch eine Modulation durch einen Betrieb von Gradientenspulen hervorgerufen wird. Insbesondere kann eine solche Kamera verwendet werden, um dynamische Feldstörungen und/oder Feldabweichungen zu kalibrieren, wie beispielsweise durch Wirbelströme verursachte, die durch ein schnelles Schalten von Gradientenpulsen verursacht werden.

Ein Satz von N Magnetfeldvektoren, insbesondere dreidimensionalen Abtastpunkten, umfasst insbesondere $3*N$ Feldwerte, die folgendermaßen ausgedrückt werden können: $B_{x,m}(x_m,y_m,z_m)$, $m=1...N$ als Projektionen des Magnetfeldvektors $\boldsymbol{B}$ an den Stellen $(x_m,y_m,z_m)$ auf eine X-Achse, $B_{y,n}(x_n,y_n,z_n)$, $n=1...N$ als Projektionen des Magnetfeldvektors $\boldsymbol{B}$ an den Stellen $(x_n,y_n,z_n)$ auf eine Y-Achse und $B_{z,o}(x_o,y_o,z_o)$, $o=1...N$ als Projektionen des Magnetfeldvektors $\boldsymbol{B}$ an den Stellen $(x_o,y_o,z_o)$ auf eine Z-Achse.

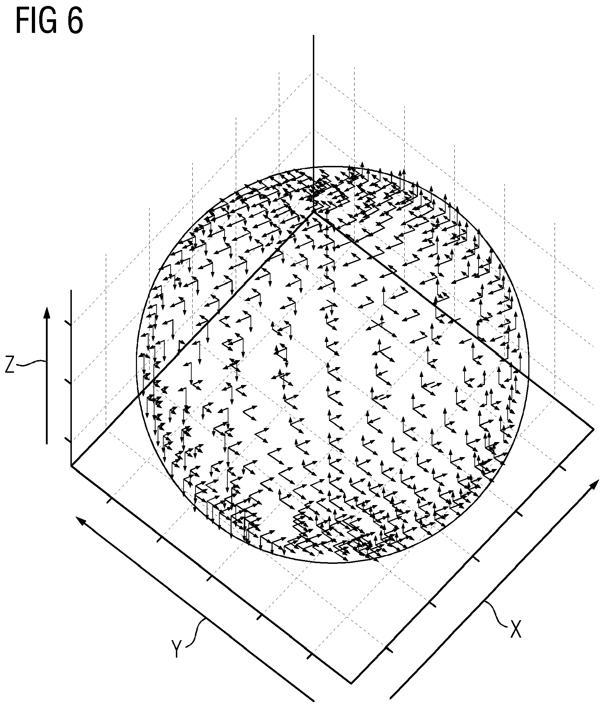

Es ist insbesondere denkbar, dass manche dieser Koordinatenwerte gleich sein können, insbesondere abhängig vom Aufbau der Feldkamera. Beispielsweise kann gelten $x_m=x_n=x_o$ für alle $m=n=o$. Fig. 6 zeigt exemplarisch Magnetfeldvektoren in einem durch eine Gradientenspule erzeugten Magnetfeld in einem statischen Zustand, d.h. der durch die Gradientenspule fließende Strom ist zeitlich konstant. An jedem Abtastpunkt sind in Form der kleinen Pfeile drei Werte dargestellt, die den drei orthogonalen Feldkomponenten $B_x$, $B_y$ and $B_z$. entsprechen. Dabei wird in diesem Fall kein Hauptmagnetfeld überlagert ($\boldsymbol{B}_0=0$), so dass der Zustand beispielsweise einem Anwendungsfall entspricht, bei dem während eines Fertigungsprozesses einer Magnetresonanzvorrichtung eine Gradientenspule vor einem Einbau in einen Hauptmagneten charakterisiert wird.

Vorzugsweise wird zur Ermittlung des Magnetfeldes das Vektormodell an die erfassten mehreren Magnetfeldvektoren gefittet. Insbesondere wird dabei ein mathematisches Modell an reale Feldwerte gefittet. Die mehreren Magnetfeldvektoren sind dabei beispielsweise die vorab beschriebenen N Magnetfeldvektoren.

Das Fitten des Models kann insbesondere als eine Kalibrierung des Vektormodells aufgefasst werden. Vorteilhafterweise ermöglicht das kalibrierte Vektormodell, dass Magnetfeldwerte an jeder Stelle innerhalb des Bildgebungsvolumens berechnet werden können. Eine Abtastung verhältnismäßig weniger Stellen N ermöglicht somit vorteilhafterweise eine Ermittlung des Magnetfelds an jeder anderen Stelle innerhalb des Bildgebungsvolumens. (Auch außerhalb des Bildgebungsvolumens kann das Vektormodell die Feldverteilung voraussagen, falls auch dieser Raum frei ist von elektrischen Strömen, d.h. $\boldsymbol{J}=0$, und Verschiebungsströmen, d.h. $d\boldsymbol{E}/dt=0$.) Vorzugsweise wird dazu Zerlegung, insbesondere eine Reihenentwicklung, in, vorzugsweise orthogonale, Basisfunktionen durchgeführt. Vorzugsweise wird Koeffizienten der Basisfunktionen ermittelt, indem das Vektormodell möglichst gut an die erfassten Magnetfeldvektoren gefittet werden. Anhand der dadurch ermittelten Koeffizienten können vorteilhafterweise Magnetfeldwerte, insbesondere Magnetfeldvektoren, an jeder beliebigen Stelle des Bildgebungsvolumens ermittelt werden.

Die Ermittlung des Modells des Vektorfeldes bzw. die Modellierung des Magnetfeldes kann für jedes Set von N erfassten Magnetfeldvektoren durchgeführt werden, beispielsweise auch für ein durch einen supraleitenden Hauptmagneten erzeugtes Hauptmagnetfeld $\boldsymbol{B}_0$, von z.B. 1.5 T oder 3 T, mit oder ohne zusätzlichem Gradientenmagnetfeld.

Ferner kann die Ermittlung des Modells des Vektorfeldes bzw. Modellierung des Magnetfeldes für jedes Set von N Magnetfeldvektoren durchgeführt werden, die zu verschiedenen Zeitpunkten t erfasst werden; es kann insbesondere eine dynamische Entwicklung des Vektorfeldes $\boldsymbol{B}(t)$ modelliert werden, z.B. für $\boldsymbol{B}(t)=\boldsymbol{B}_0+\boldsymbol{B}_g(t)$, wobei $\boldsymbol{B}_0$ ein statisches Hauptmagnetfeld und $\boldsymbol{B}_g(t)$ ein veränderliches Gradientenmagnetfeld sind. Hierbei resultiert das gesamte Magnetfeld $\boldsymbol{B}(t)$ aus einer vektoriellen Addition des Hauptmagnetfelds $\boldsymbol{B}_0$ mit dem Gradientenmagnetfeld $\boldsymbol{B}_g(t)$.

Insbesondere kann ein Magnetfeld einer ein Magnetfeld erzeugenden Komponente einer Magnetresonanzvorrichtung ermittelt werden. Insbesondere kann ein durch eine Gradientenspuleneinheit erzeugtes Gradientenmagnetfeld außerhalb einer Magnetresonanzvorrichtung ermittelt, insbesondere modelliert, werden. Dies kann beispielsweise zur Qualitätskontrolle während der Herstellung der Magnetresonanzvorrichtung durchgeführt werden. Dazu kann die Gradientenspuleneinheit beispielsweise mit einem konstanten Strom und/oder dynamischen Strompulsen betrieben werden.

Ferner kann ein durch einen, beispielsweise supraleitenden, Hauptmagneten erzeugtes statisches Hauptmagnetfeld ermittelt, insbesondere modelliert, werden. Dies kann beispielsweise während der Herstellung der Magnetresonanzvorrichtung durchgeführt werden, insbesondere wenn der Hauptmagnet noch nicht innerhalb eines Heliumbehälters verschlossen ist. Insbesondere kann dies bei einer Qualitätskontrolle im Rahmen eines Raumtemperaturplots (engl. room temperature plot, RTP) und/oder eines Niederstromplots (engl. low current plot, LCP) erfolgen.

Vorteilhafterweise kann zur Ermittlung des Magnetfeldes das Modell des Vektorfeldes in separate, insbesondere orthogonale, Teilmodelle zerlegt werden. Wie bereits dargestellt wurde, kann für jede der drei skalaren Komponenten *Bx, By* and *Bz* ein separates Feldmodell kalibriert werden. Ferner können diese skalaren Komponenten kombiniert werden, um ein Vektormodell für eine Vektorfeldverteilung zu erhalten. Dafür kann der Ausdruck $\boldsymbol{B} = i B_x + j B_y + k B_z$ verwendet werden.

Vorzugsweise umfasst die Ermittlung des Modells des Vektorfeldes eine Entwicklung des Vektorfeldes nach, insbesondere skalaren und reellwertigen, Kugelflächen-Basisfunktionen. Gemäß den vorangehenden Ausführungen kann insbesondere eine Feldzerlegung durchgeführt werden, für die als Basisfunktionen skalare und reellwertige Kugelflächenfunktionen ausgedrückt in kartesischen Koordinaten verwendet werden.

Im Folgenden repräsentiert die Notation $\boldsymbol{B}^*(\boldsymbol{r})$ aus dem Modell des Vektorfeldes abgeschätzte Feldwerte. Die Notation $\boldsymbol{B}(\boldsymbol{r})$ repräsentiert tatsächliche Feldwerte. In kartesischen Koordinaten kann das Modell des Vektorfeldes aus-

$$\boldsymbol{B}^*(\boldsymbol{r}) = i B_x^*(\boldsymbol{r}) + j B_y^*(\boldsymbol{r}) + k B_z^*(\boldsymbol{r}) \ .$$

gedrückt werden durch

Insbesondere kann ein skalares Feldmodell für jede orthogonale Feldkomponente optimiert werden durch eine, insbesondere finite, Reihenentwicklung nach skalaren Kugelflächenfunktionen.

Vorzugsweise wird zur Ermittlung des Magnetfeldes das Vektormodell an die erfassten mehreren Magnetfeldvektoren gefittet. Insbesondere können anhand der erfassten Magnetfeldvektoren die Koeffizienten der Reihenentwicklung so optimiert werden, dass das abgeschätzte Magnetfeld $\boldsymbol{B}^*(\boldsymbol{r})$ möglichst gut mit dem tatsächlichen Magnetfeld $\boldsymbol{B}(\boldsymbol{r})$ übereinstimmt. Mit den dadurch gemittelten Koeffizienten kann das Magnetfeld an jeder beliebigen Stelle, insbesondere innerhalb des Bildgebungsvolumens, bestimmt werden.

Die drei orthogonalen Komponenten des Vektorfeldes können folgendermaßen ausgedrückt werden:

$$B_x^*(\boldsymbol{r}) = \sum_{h=1}^{H} CX_h \cdot SH_h(\boldsymbol{r})$$

$$B_y^*(\boldsymbol{r}) = \sum_{h=1}^{H} CY_h \cdot SH_h(\boldsymbol{r})$$

$$B_z^*(\boldsymbol{r}) = \sum_{h=1}^{H} CZ_h \cdot SH_h(\boldsymbol{r})$$

Damit kann das Vektorfeldmodell als Summe von skalaren Kugelflächenfunktionen $SH_h(\boldsymbol{r})$ beschrieben werden, die durch einen vektoriellen Reihenentwicklungskoeffizienten $C_h = (i CX_h + j CY_h + k CZ_h)$ gewichtet sind:

$$\boldsymbol{B}^*(\boldsymbol{r}) = \sum_{h=1}^{H} (i CX_h + j CY_h + k CZ_h) \cdot SH_h(\boldsymbol{r}) = \sum_{h=1}^{H} \boldsymbol{C}_h \cdot SH_h(\boldsymbol{r})$$

Aus der Anzahl der Entwicklungsterme *H* ergibt sich die Genauigkeit des Feldmodells; ein höheres *H* resultiert in einer höheren Genauigkeit auf Kosten eines höheren Berechnungsaufwands. Vorzugsweise eignet sich eine höhere Anzahl von Entwicklungsterme *H,* wenn auch eine höhere Anzahl an Magnetfeldvektoren erfasst werden. Vorteilhafterweise wird eine Anzahl von Entwicklungstermen *H* gewählt, welche einerseits ausreichend ist, um der Komplexität des zu ermittelnden Magnetfeldes gerecht zu werden und andererseits den Berechnungsaufwand minimiert.

Die reellwertigen Koeffizienten $CX_h$, $CY_h$ und $CZ_h$, $h=1...H$ sind während des Fittens zu optimierende Modellparameter. Der Ortsvektor $r$ beschreibt die örtliche Stelle des Magnetfeldes. Er kann insbesondere in kartesischen Koordinaten $r(x,y,z)$, Kugelkoordinaten $r(r,\theta,\phi)$ oder andere geeignete Koordinaten ausgedrückt werden. Die als Basis-funktionen verwendeten Kugelflächenfunktionen $SH_h$, $h=1...H$ können gemäß der zweiten Spalte der in Fig. 4 dargestellten Tabelle gewählt werden, wobei die Indizes gemäß der Ordnung $l$ ansteigen. Beispielsweise weist eine Feldzerlegung bis zur zweiten Ordnung, d.h. $l=0,1$ und 2, die ersten neun der in der Tabelle angegebenen Kugelflächenfunktionen auf. Das bedeutet, dass jedes Feldmodell $H=9$ Parameter bzw. Koeffizienten umfasst, die gefittet werden. Um ein genaueres Magnetfeldmodell zu erhalten, kann beispielsweise eine Reihenentwicklung bis $H=16$ durchgeführt werden mit den Kugelflächenfunktionen $SH_h$ bis zur dritten Ordnung, also $l=0,1,2$, und 3, so dass 16 Parameter bzw. Koeffizienten ermittelt werden. Um eine noch höhere Genauigkeit zu erreichen, kann auch eine höhere Anzahl an Entwicklungstermen $H>16$ verwendet werden. Ferner ist auch möglich eine unterschiedliche Anzahl von Entwicklungstermen für die verschiedenen Feldkomponenten $X$, $Y$ und $Z$ zu verwenden, d.h. $H_x{\neq}H_y{\neq}H_z$.

Im Folgenden wird ein mögliches Fitten des Magnetfeldmodells auf das tatsächliche Magnetfeld, insbesondere die erfassten Magnetfeldvektoren, dargestellt. Insbesondere umfasst das Fitten des Vektormodells an die erfassten mehreren Magnetfeldvektoren eine Ermittlung von den Kugelflächen-Basisfunktionen zugeordneten Koeffizienten. Vorzugsweise wird zur Ermittlung der den Kugelflächen-Basisfunktionen zugeordneten Koeffizienten ein, insbesondere lineares, Gleichungssystem gelöst.

Das Fitten erfolgt beispielsweise durch ein Anpassen der Modellparameter $CX_h$, $CY_h$ and $CZ_h$. Im folgenden Ausführungsbeispiel wird ein Fitten für die Feldkomponente $X$ dargestellt. Dies kann ohne Weiteres auf die anderen Feldkomponente $Y$ und $Z$ übertragen werden.

Beispielsweise werden für $N$ Magnetfeldvektoren $\boldsymbol{B}$ an den Stellen $\boldsymbol{r}_m$, $m=1...N$ die Messwerte $B_{x,m}(x_m,y_m,z_m)$ erfasst, wobei diese Messwerte Projektionen des Vektors $\boldsymbol{B}_m$ auf die $X$-Achse sind. Wie bereits ausgeführt, kann die orthogonale Komponenten $X$ des Vektorfeldes ausgedrückt werden mit

$$B_X^*(\boldsymbol{r}) = \sum_{h=1}^{H} CX_h \cdot SH_h(\boldsymbol{r})$$

Durch Anwenden dieser Gleichung auf die erfassten Messwerte erhält man ein System von $N$ unabhängigen Gleichungen für $H$ unbekannte Koeffizienten $CX_h$, $h = 1...H$:

$$B_X^*(\boldsymbol{r_m}) = \sum_{h=1}^{H} CX_h \cdot SH_h(\boldsymbol{r_m})$$

Dieses Gleichungssystem ist für $N = H$ bestimmt bzw. für $N > H$ überbestimmt. Dem Fachmann sind verschiedene Methoden bekannt, um solche ein Gleichungssystem zu lösen. Beispielsweise kann eine Methode der kleinsten Quadrate (engl. englisch ordinary least squares, OLS) angewendet werden, um ein überbestimmtes Gleichungssystem zu lösen. Ein weiteres mögliches Verfahren zur Ermittlung der unbekannten Koeffizienten $CX_h$ kann eine Reformulierung als Optimierungsproblem und eine Minimierung einer Kostenfunktion umfassen, die beispielsweise ausgedrückt wird als Summe der kleinsten Quadrate des Fitting-Fehlers

$$\min \sum_{m=1}^{N} [B_X(\boldsymbol{r_m}) - B_X^*(\boldsymbol{r_m})]^2$$

Ferner können zur Ermittlung des Magnetfeldes, insbesondere des das Magnetfeld beschreibende Vektormodells, einige geeignete Software-Werkzeuge, -Bibliotheken und -Open-Source-Code verwendet werden, wie z.B. Matlab oder Mathematica.

Um das komplette Vektormodell des Magnetfeldes zu erhalten, kann das oben beschriebene Verfahren für die Feldkomponente $X$ auch für die Feldkomponenten $Y$ und $Z$ analog angewendet, insbesondere wiederholt, werden, so dass man $\boldsymbol{B}_y{}^*(r)$ und $\boldsymbol{B}_z{}^*(r)$ erhält.

Vorzugsweise kann die Ermittlung des Magnetfeldes eine Ermittlung eines dynamischen Modells eines Vektorfeldes umfassen Insbesondere kann ein dynamisches Modell eines Vektorfeldes, insbesondere mit einer nicht-stationären zeitlichen Entwicklung, in Zeitfenstern einer Magnetresonanzmessung gemäß einem oben beschriebenen Verfahren kalibriert werden. Insbesondere kann dies dazu führen, dass für Modellparameter $CX_h$, $CY_h$ and $CZ_h$, $h = 1...H$ unterschiedliche Werte in den verschiedenen Zeitfenstern ermittelt werden.

Neben dem hier dargestellten Verfahren zur Zerlegung und/oder Modellierung des Vektorfeldes können noch weitere andere Verfahren denkbar.

Eine Ausführungsform des Verfahrens sieht vor, dass anhand des dynamischen Modells des Vektorfeldes eine Vektor-Gradientenimpulsantwortfunktion *VGIRF* (engl. vector gradient impulse response function) kalibriert wird. Diese Kalibrierung kann insbesondere für alle drei Gradientenachsen *X, Y,* und *Z* erfolgen.

Zur Kalibrierung der *VGRIF* kann insbesondere eine Gradientenspule der Gradientenspuleneinheit, beispielsweise für die *X*-Achse, mit einem Strom einer vorbestimmten Form, beispielsweise in Form eines Rechteckpulses oder eines Dreieckpulses, betrieben. Daraus kann die Gradientenimpulsantwortfunktion, gemäß dem Beispiel für die X-Achse: *VGIRFX,* aus der dynamischen Entwicklung des Vektorfelds berechnet werden. Vorteilhafterweise kann anhand der kalibrierten Gradientenimpulsantwortfunktion *VGIRFX* das aus einem beliebigen Stromfluss $I_x(t)$ durch die Gradienten-spule für die *X*-Achse resultierende Gradientenmagnetfeld $BGX(r,t)$ anhand einer Faltung (engl. convolution) der Gradientenimpulsantwortfunktion *VGIRFX* und dem Stromfluss $I_x(t)$ ermittelt werden:

$$BGX(r,t) = VGIRFX \otimes I_x(t)$$

Analog kann auf für die Y-Achse und die Z-Achse die Gradientenimpulsantwortfunktionen *VGIRFY* und *VGIRFZ* ermittelt und zur Bestimmung der Gradientenmagnetfelder $BGY(r,t)$ und $BGZ(r,t)$ angewendet werden.

Ferner wird vorgeschlagen, dass zur Ermittlung des Magnetfeldes mehrere Teilbeiträge des Magnetfeldes vektoriell kombiniert, insbesondere addiert, werden. Insbesondere können verschiedene kalibrierte Vektorfeldmodelle kombiniert werden, um Abweichungen des Magnetfeldes, insbesondere bei einer bildgebenden Magnetresonanzmessung, zu korrigieren. Solche Abweichungen können beispielsweise in einer ungleichmäßigen, insbesondere inhomogenen, Verteilung des (statischen) Hauptmagnetfelds B0 und/oder in einer nicht-idealen, insbesondere nicht-linearen, Verteilung eines Gradientenmagnetfeldes, das üblicherweise zur Ortskodierung von Magnetresonanzsignalen eingesetzt wird, bestehen. Solche Abweichungen sind insbesondere bekannt als Nichtlinearitäten, inhärente Maxwell-Terme, "comcomitant" oder "crossover" Terme. Eine weitere mögliche Quelle für Abweichungen des Magnetfelds sind auftretende Wirbelströme.

Zur vereinfachten Darstellung wird im Folgenden hinsichtlich der Notation nicht mehr zwischen dem tatsächlichen Magnetfeldverteilung *B*(*r*) und der modellierten Magnetfeldverteilung *B**(*r*) unterschieden; in den meisten Fällen beziehen sich diese Notation auf die anhand des kalibrierten Modells berechneten Feldwerte.

Insbesondere wird vorgeschlagen, die Feldwerte der vorgehend beschriebenen Feldmodelle zu kombinieren, insbesondere zu addieren, um dadurch ein vollständiges Modell des Vektorfeldes zu erhalten. Dieses Modell deckt vorzugsweise das gesamte Bildgebungsvolumen ab, der insbesondere zur Bildrekonstruktion und/oder zur Feldkorrektur verwendet werden kann.

Gemäß dem Stand der Technik werden skalare Feldmodelle für den Betrag des Magnetfeldes *B*, insbesondere für des Hauptmagnetfelds $B_0$ und der Gradientenmagnetfelder *GX, GY* und *GZ,* verwendet; diese skalaren Feldmodelle werden zu einem vollständigen Feldmodell skalar aufaddiert, d.h. $B(r)=B_0(r)+ GX(r)+GY(r)+GZ(r)$.

Im Gegensatz zum Stand der Technik werden hier keine skalare Feldmodelle, sondern vektorielle Feldmodelle vorgeschlagen. Dadurch ist vorteilhafterweise nicht nur die Feldstärke entlang der Hauptachse, also üblicherweise der *Z*-Achse, bekannt, sondern zudem auch die Feldwerte entlang der dazu orthogonalen *X*- und *Y*-Achsen. Abweichend vom Stand der Technik wird vorgeschlagen, eine vektorielle Summe der einzelnen Feldbeiträge zu bilden. Die Feldbeiträge umfassen insbesondere das Hauptmagnetfeld und die Gradientenmagnetfelder. Vorzugsweise werden die Magnetfelder anhand von Vektoren mit drei orthogonalen kartesischen Komponenten dargestellt, so dass die Addition der Magnetfelder auf drei skalare Additionen der Komponenten reduziert werden kann.

Wird beispielsweise ein Hauptmagnetfeld $B_0(r)=iB_{0x}(r)+jB_{0y}(r)+ kB_{0z}(r)$ und ein Gradientenmagnetfeld der Gradientenspule der *X*-Achse $GX(r)=iGX_x(r) + jGX_y(r) + kGX_z(r)$ erzeugt, ergibt sich das Magnetfeld ausgedrückt durch Vektoren $B(r)=B_0(r)+GX(r)$; für jede Komponente kann das Magnetfeld durch skalare Größen ausgedrückt werden: $B_x(r)=B_0x(r)+GX_x(r)$, $B_y(r)=B_0y(r)+GX_y(r)$ und $B_z(r) = B_0z(r) + GX_z(r)$.

Werden beispielsweise gleichzeitig jeweils ein Teil-Gradientenmagnetfeld durch die Gradientenspulen der *X*-Achse, der *Y*-Achse und der *Z*-Achse neben dem Hauptmagnetfeld erzeugt, was insbesondere bei Magnetresonanzsequenzen mit einer spiralen und/oder radialen Trajektorie vorgesehen sein kann, dann kann die Summe der Vektorfelder $B(r)=B_0(r)+GX(r)+GY(r) +GZ(r)$ durch ihre skalaren Komponenten ausgedrückt werden mit $B_x(r)=B_0x(r)+GX_x(r)+GY_x(r)+GZ_x(r)$, $B_y(r)=B_0y(r)+GX_y(r)+GY_y(r)+ GZ_y(r)$ und $B_z(r)=B_0z(r)+GX_z(r)+GY_z(r)+GZ_z(r)$.

Es ist aber auch denkbar, ein Magnetfeld zu ermitteln, das keinen Beitrag durch ein statisches Hauptmagnetfeld umfasst, sondern nur Beiträge von einem oder mehreren Gradientenmagnetfeldern. Dies kann beispielsweise nützlich sein, um die Gradientenspuleneinheit während eines Fertigungsprozesses einer Magnetresonanzvorrichtung zu charakterisieren, insbesondere zur Qualitätskontrolle, bevor die Gradientenspuleneinheit in den Hauptmagneten eingebaut wird. Die erfassten mehreren Magnetfeldvektoren können insbesondere verwendet werden, um für jede Gradientenachse ein separates Magnetfeldmodell zu kalibrieren. Da in diesem Fall kein Hauptmagnetfeld vorhanden ist, d.h. $B_0(r)$=0, wird nur das von der Gradientenspuleneinheit erzeugte Gradientenmagnetfeld abgetastet, beispielsweise ein wie in Fig. 3 dargestelltes Gradientenmagnetfeld, das von einer der X-Achse zugeordneten Gradientenspule erzeugt werden. Das hierfür ermittelte Modell des Vektorfeldes ermöglicht vorteilhafterweise eine Berechnung des durch diese Gradientenspule erzeugten Gradientenmagnetfeldes $GX(r,ix)$ für jeden beliebigen Stromfluss ix an jeder beliebigen Stelle $r$ innerhalb des Bildgebungsvolumens. Analog kann auch für die der Y-Achse und der Z-Achse zugeordneten Gradientenspulen der Gradientenspuleneinheit ein Modell des Vektorfeldes ermittelt werden.

Eine weitere Ausführungsform des Verfahrens sieht vor, ein Gradientenmagnetfeld zu ermitteln, wobei neben dem Gradientenmagnetfeld ein dieses überlagerndes Hauptmagnetfeld gegeben ist. Dazu werden beispielsweise mehrere Magnetfeldvektoren eines Magnetfeldes am Rand des Bildgebungsvolumens erfasst. Das Hauptmagnetfeld kann insbesondere Inhomogenitäten aufweisen. Das Gradientenmagnetfeld wird beispielsweise durch einen konstanten Stromfluss ix durch eine der X-Achse zugeordneten Gradientenspule betrieben; an verschiedenen Stellen $r$ werden mehrere Magnetfeldvektoren $B(r,ix)=B_0(r)+ GX(r,ix)$ erfasst. Vorzugsweise wird zudem das Hauptmagnetfeld $B_0(r)$ kalibriert; dazu werden ebenso an den verschiedenen Stellen $r$ Magnetfeldvektoren erfasst, wobei der Stromfluss ix während dieser Erfassung gleich Null ist, d.h. ix=0. Das Feldmodell für die der X-Achse zugeordnete Gradientenspule kann aus einer Subtraktion der Modelle der Vektorfelder ermittelt werden: $GX(r,ix)=B(r,ix)-B_0(r)$

Neben diesen detailliert beschriebenen Ausführungsformen kombinierter Modelle von Vektorfeldern, sind auch andere Ausführungsformen denkbar, beispielsweise eine Kombination eines Hauptmagnetfeldes mit mehreren, insbesondere drei Gradientenmagnetfeldern.

Ferner wird vorgeschlagen, anhand des in Form eines Modells eines Vektorfeldes ermittelten Magnetfeldes $B(r)$ eine örtliche Stärke des Magnetfeldes $B(r)$ zu ermitteln. Insbesondere kann dazu der Betrag $B(r)=|B(r)|$ des Vektorfeldes ermittelt werden. Vorzugsweise werden anhand der Stärke des Magnetfeldes $B(r)$ Magnetresonanzsignale modelliert und/oder ausgewertet. Beispielsweise kann die Kreisfrequenz $\omega(r)$ eines an einer Stelle $r$ entstandenen Magnetresonanzsignals ermittelt werden mit $\omega(r)=\gamma|B(r)|$, wobei $\gamma$ das gyromagnetische Verhältnis von Wasserprotonen ist.

Eine weitere Ausführungsform des Verfahrens sieht vor, dass an zumindest einer der verschiedenen Stellen ein erster Ort einer Erfassung einer ersten Komponente des an dieser Stelle erfassten Magnetfeldvektors einen Versatz zu einem zweiten Ort einer zweiten Komponente des an dieser Stelle erfassten Magnetfeldvektors aufweist, wobei der Versatz bei der Ermittlung des Magnetfeldes berücksichtigt wird.

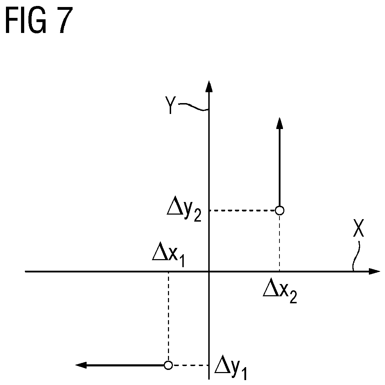

Zur Verdeutlichung ist in Fig. 7 ein Magnetometer zur Erfassung eines Magnetfeldvektors an einer bestimmten Stelle $r_m$, m=1...N dargestellt. Um die Darstellung zu vereinfachen, umfasst dieser nur zwei unabhängige Teilsensoren, davon einer zur Erfassung einer Komponente in X-Richtung und ein weiterer zur Erfassung einer Komponente in Y-Richtung. Vorteilhafterweise umfasst der Magnetometer auch einen hier nicht dargestellten Teilsensor zur Erfassung einer Komponente in Z-Richtung. Gegenüber einem Referenzpunkt weisen die Teilsensoren einen, üblicherweise kleinen, Versatz auf. So ist beispielsweise der Teilsensor zur Erfassung der Komponente in X-Richtung um $\Delta x_1$ und in Y-Richtung um $\Delta y_1$ versetzt. Bestünde dieser Versatz nicht, würden alle drei orthogonalen Vektorkomponenten $B_x(r_m)$, $B_y(r_m)$ und $B_z(r_m)$ des Magnetfeldvektors $B(r_m)$ am exakt gleichen Ort $r_m$ gemessen werden.

Vorteilhafterweise wird bei der Ermittlung des Magnetfeldes berücksichtigt, dass etwaige Magnetometer drei unabhängige Teilsensoren aufweisen, wobei jeder der Teilsensoren für eine der Raumrichtungen X, Y oder Z vorgesehen ist und relativ zueinander einen Versatz aufweisen. Insbesondere erfasst ein solcher Magnetometer die orthogonalen Komponenten $B_x$, $B_y$ und $B_z$ des Magnetfeldvektors B an jeweils einem etwas anderen Ort. Das kann auf folgende Weise ausgedrückt werden: $B_x(x_1,y_1,z_1)$ ist die Projektion des Vektors $B(x_1,y_1,z_1)$ am Ort $(x_1,y_1,z_1)$ auf die X-Achse. $B_y(x_2,y_2,z_2)$ ist die Projektion des Vektors $B(x_2,y_2,z_2)$ am Ort $(x_2,y_2,z_2)$ auf die Y-Achse. $B_z(x_3,y_3,z_3)$ ist die Projektion des Vektors $B(x_3,y_3,z_3)$ am Ort $(x_3,y_3,z_3)$ auf die Z-Achse.

Die Orte $(x_1,y_1,z_1)$, $(x_2,y_2,z_2)$ und $(x_3,y_3,z_3)$ sind üblicherweise in unmittelbarer Nähe zum Abtastpunkt $r$. Sie können beschrieben werden durch folgende Formulierung:

$$r_m = \{ (x_{1m}, y_{1m}, z_{1m}), (x_{2m}, y_{2m}, z_{2m}), (x_{3m}, y_{3m}, z_{3m}) \}$$

Im Folgenden wird wieder die Notation $B^*(r)$ für aus dem Modell des Vektorfeldes abgeleitete Feldwerte und die Notation $B(r)$ für, insbesondere durch das Magnetometer, erfasste Feldwerte verwendet. Vorzugsweise wird das Vektorfeld durch eine gewichtete Summe der Vektor-Kugelflächenfunktionen VSH gemäß der in Fig. 4 dargestellten Tabelle modelliert:

$$B^{*}\left(\boldsymbol{r}\right)=\sum_{h=1}^{H}C_{h}\cdot VSH_{h}\left(\boldsymbol{r}\right)$$

Die reellwerten Koeffizienten $C_h$, h=1...$H$ sind die optimierenden Modellparameter, um einen möglichst guten Fit zu erreichen, Die Ortsvektor $\boldsymbol{r}(x,y,z)= \boldsymbol{i}x+\boldsymbol{j}y+\boldsymbol{k}z$ beschreibt die Stelle, an der das Magnetfeld ausgewertet wird. Die Werte der Feldkomponenten an den Orten, an denen jede einzelne Feldkomponente gemessen werden, können folgendermaßen ausgedrückt werden: $B^{*}_x(x_{1m},y_{1m},z_{1m})=\boldsymbol{i}\cdot\boldsymbol{B}^{*}(x_{1m},y_{1m},z_{1m})$, $B^{*}_y(x_{2m},y_{2m},z_{2m})=\boldsymbol{j}.\boldsymbol{B}^{*}(x_{2m},y_{2m},z_{2m})$ und $B^{*}_z(x_{3m},y_{3m},z_{3m})= \boldsymbol{k}\cdot\boldsymbol{B}^{*}(x_{3m},y_{3m},z_{3m})$. Das Symbol "." steht hier für ein Skalarprodukt von zwei Vektoren. Wendet man für die Gesamtzahl von 3*$N$ erfassten Magnetfeldwerten erfasst an den Stellen $\boldsymbol{r}_m$, m=l...$N$, die vorangehenden Gleichungen an, erhält man eine Anzahl von 3*$N$ unabhängigen linearen Gleichungen mit einer Anzahl von $H$ Unbekannten $C_h$, h=l...$H$. Mögliche Methoden zur Lösung eines solchen Gleichungssystems wurden bereits oben dargestellt.

Es wird abschließend noch einmal darauf hingewiesen, dass es sich bei den vorhergehend detailliert beschriebenen Verfahren sowie bei der dargestellten Auswerteeinheit und Magnetresonanzvorrichtung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

**Patentansprüche**

1. Verfahren zur Ermittlung eines Magnetfeldes zumindest einer Magnetspuleneinheit einer Magnetresonanzvorrichtung, insbesondere eines Hauptmagneten zum Erzeugen eines Hauptmagnetfeldes und/oder eine Gradientenspuleneinheit zum Erzeugen eines Gradientenmagnetfeldes,
   wobei das Verfahren umfasst:

   Erzeugen des Magnetfelds durch die zumindest eine Magnetspuleneinheit,
   Erfassen mehrerer Magnetfeldvektoren an verschiedenen Stellen des Magnetfeldes mittels einer Magnetfeldsensoreinheit,
   wobei jeder der mehreren Magnetfeldvektoren eine Stärke, insbesondere einen Betrag, und eine Richtung des Magnetfeldes an der jeweiligen Stelle beschreibt,
   Ermittlung des Magnetfeldes, wobei zur Ermittlung des Magnetfeldes anhand der mehreren Magnetfeldvektoren ein Modell eines Vektorfeldes ermittelt wird.

2. Verfahren nach Anspruch 1,
   wobei die verschiedenen Stellen, an denen die mehreren Magnetfeldvektoren erfasst werden, auf einer Fläche liegen, die ein Volumen des zu ermittelnden Magnetfeldes, insbesondere eines Bildgebungsvolumen einer Magnetresonanzmessung, einschließt.

3. Verfahren nach Anspruch 2,
   wobei die Fläche eine sphärische Fläche ist.

4. Verfahren nach einem der vorangehenden Ansprüche,
   wobei anhand des ermittelten Magnetfeldes eine Qualitätskontrolle des Hauptmagneten und/oder der Gradientenspuleneinheit während der Herstellung der Magnetresonanzvorrichtung durchgeführt wird.

5. Verfahren nach einem der vorangehenden Ansprüche,
   wobei zur Ermittlung des Magnetfeldes das Modell des Vektorfeldes in separate, insbesondere orthogonale, Teilmodelle zerlegt wird.

6. Verfahren nach einem der vorangehenden Ansprüche,
   wobei die Ermittlung des Modells des Vektorfeldes eine Entwicklung des Vektorfeldes nach, insbesondere skalaren und reellwertigen, Kugelflächen-Basisfunktionen umfasst.

7. Verfahren nach einem der vorangehenden Ansprüche,
wobei zur Ermittlung des Magnetfeldes das Vektormodell an die erfassten mehreren Magnetfeldvektoren gefittet wird.

8. Verfahren nach Anspruch 7,
wobei das Fitten des Vektormodells an die erfassten mehreren Magnetfeldvektoren eine Ermittlung von den Kugelflächen-Basisfunktionen zugeordneten Koeffizienten umfasst.

9. Verfahren nach Anspruch 8,
wobei zur Ermittlung der den Kugelflächen-Basisfunktionen zugeordneten Koeffizienten ein, insbesondere lineares, Gleichungssystem gelöst wird.

10. Verfahren nach einem der vorangehenden Ansprüche,
wobei die Ermittlung des Magnetfeldes eine Ermittlung eines dynamischen Modells eines Vektorfeldes umfasst.

11. Verfahren nach Anspruch 10,
wobei anhand des dynamischen Modells des Vektorfeldes eine Vektor-Gradientenimpulsantwortfunktion kalibriert wird.

12. Verfahren nach einem der vorangehenden Ansprüche.
wobei zur Ermittlung des Magnetfeldes mehrere Teilbeiträge des Magnetfeldes vektoriell kombiniert, insbesondere addiert, werden.

13. Verfahren nach einem der vorangehenden Ansprüche,
wobei an zumindest einer der verschiedenen Stellen ein erster Ort einer Erfassung einer ersten Komponente des an dieser Stelle erfassten Magnetfeldvektors einen Versatz zu einem zweiten Ort einer zweiten Komponente des an dieser Stelle erfassten Magnetfeldvektors aufweist,
wobei der Versatz bei der Ermittlung des Magnetfeldes berücksichtigt wird.

14. Vorrichtung zur Ermittlung eines Magnetfeldes zumindest einer Magnetspuleneinheit nach einem der Ansprüche 1 bis 13 umfassend:

eine Magnetspuleneinheit zum Erzeugen des Magnetfelds,
eine Magnetfeldsensoreinheit zum Erfassen mehrerer Magnetfeldvektoren an verschiedenen Stellen des Magnetfeldes,
eine Auswerteeinheit zur Ermittlung des Magnetfeldes.

15. Computerprogrammprodukt, welches ein Programm umfasst und direkt in einen Speicher einer programmierbaren Auswerteeinheit ladbar ist, mit Programmmitteln, um eine Ermittlung eines Magnetfeldes gemäß einem Verfahren nach einem der Ansprüche 1 bis 13 durchzuführen, wenn das Programm in der Auswerteeinheit ausgeführt wird.

FIG 1

FIG 2

S10

S20

S30

S40

FIG 3

# FIG 4

| 1 | SSH | VSH | | |
| --- | --- | --- | --- | --- |
| | | $F_x$ | $F_y$ | $F_z$ |
| 0 | 1 | n. a. | n. a. | n. a. |
| 1 | x | 1 | 0 | 0 |
| | y | 0 | 1 | 0 |
| | z | 0 | 0 | 1 |
| 2 | xy | y | x | 0 |
| | zy | 0 | z | y |
| | $2z^2 - x^2 - y^2$ | $-2x$ | $-2y$ | $4z$ |
| | xz | z | 0 | x |
| | $x^2 - y^2$ | $2x$ | $-2y$ | 0 |
| 3 | $3x^2 y - y^3$ | $6xy$ | $3x^2 - 3y^2$ | 0 |
| | xyz | yz | xz | xy |
| | $4yz^2 - x^2 y - y^3$ | $-2xy$ | $4z^2 - x^2 - 3y^2$ | $8yz$ |
| | $2z^3 - 3x^2 z - 3y^2 z$ | $-6xz$ | $-6yz$ | $6z^2 - 3x^2 - 3y^2$ |
| | $4xz^2 - x^3 - xy^2$ | $4z^2 - 3x^2 - y^2$ | $-2xy$ | $8xz$ |
| | $x^2 z - y^2 z$ | $2xz - y^2$ | $-2yz$ | $x^2 - y^2$ |
| | $x^3 - 3xy^2$ | $3x^2 - 3y^2$ | $-6xy$ | 0 |

FIG 5

FIG 6

FIG 7

**Europäisches Patentamt**
**European Patent Office**
**Office européen des brevets**

# EUROPÄISCHER RECHERCHENBERICHT

**Nummer der Anmeldung**

EP 21 17 9707

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 582 886 A1 (UNIV ZUERICH [CH]; ETH ZUERICH ETH TRANSFER [CH]) 5. Oktober 2005 (2005-10-05) | 1-3, 5-10, 12-15 | INV. G01R33/24 G01R33/565 |
| A | * Abbildungen 1,8,9,10 * * Absatz [0002] - Absatz [0008] * * Absatz [0013] * * Absatz [0036] - Absatz [0040] * * Anspruch 21 * ----- | 11 | |
| X | EP 1 748 300 A1 (ESAOTE SPA [IT]) 31. Januar 2007 (2007-01-31) | 1-9, 12-15 | |
| A | * Absatz [0001] - Absatz [0013] * ----- | 11 | |
| A | US 2018/292502 A1 (ATALAR ERGIN [TR] ET AL) 11. Oktober 2018 (2018-10-11) * Abbildung 10 * * Absatz [0026] - Absatz [0038] * ----- | 1-15 | |
| A | US 2020/069293 A1 (JULIAN DOMINICO P [US] ET AL) 5. März 2020 (2020-03-05) * Absatz [0066] - Absatz [0067] * * Absatz [0092] * ----- | 1-15 | **RECHERCHIERTE SACHGEBIETE (IPC)** G01R |
| A | S. JOHANNA VANNESJO ET AL: "Image reconstruction using a gradient impulse response model for trajectory prediction", MAGNETIC RESONANCE IN MEDICINE, Bd. 76, Nr. 1, 1. Juli 2016 (2016-07-01), Seiten 45-58, XP055357586, US ISSN: 0740-3194, DOI: 10.1002/mrm.25841 * Abschnitt "METHODS" * ----- | 1-15 | |

Der vorliegende Recherchenbericht wurde für alle Patentansprüche erstellt

| Recherchenort | Abschlußdatum der Recherche | Prüfer |
|---|---|---|
| München | 10. November 2021 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.........................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
### ÜBER DIE EUROPÄISCHE PATENTANMELDUNG NR.

EP 21 17 9707

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-11-2021

| Im Recherchenbericht angeführtes Patentdokument | Datum der Veröffentlichung | Mitglied(er) der Patentfamilie | Datum der Veröffentlichung |
|---|---|---|---|
| EP 1582886 A1 | 05-10-2005 | EP 1582886 A1<br>US 2005218892 A1 | 05-10-2005<br>06-10-2005 |
| EP 1748300 A1 | 31-01-2007 | AT 441871 T<br>EP 1748300 A1<br>ES 2332277 T3<br>US 2007035298 A1 | 15-09-2009<br>31-01-2007<br>01-02-2010<br>15-02-2007 |
| US 2018292502 A1 | 11-10-2018 | US 2018292502 A1<br>WO 2018186815 A1 | 11-10-2018<br>11-10-2018 |
| US 2020069293 A1 | 05-03-2020 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5055791 A
- US 20150338475 A1

**In der Beschreibung aufgeführte Nicht-Patentliteratur**

- **M.A. BERNSTEIN et al.** Concomitant gradient terms in phase contrast MR: Analysis and correction. *Magnetic Resonance in Medicine,* 2021, vol. 39 (2), 300-308